(19) Europäisches Patentamt / European Patent Office / Office européen des brevets

(11) **EP 3 855 201 A1**

(12) **EUROPEAN PATENT APPLICATION**

(43) Date of publication:
**28.07.2021 Bulletin 2021/30**

(51) Int Cl.:
***G01R 33/561*** (2006.01)     ***G01R 33/48*** (2006.01)

(21) Application number: **20153458.3**

(22) Date of filing: **23.01.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **Siemens Healthcare GmbH**
  **91052 Erlangen (DE)**
- **Centre Hospitalier Universitaire Vaudois**
  **1011 Lausanne (CH)**

(72) Inventors:
- **HILBERT, Tom**
  **1006 Lausanne (CH)**
- **KOBER, Dr. Tobias**
  **1007 Lausanne (CH)**
- **FORMAN, Dr. Christoph**
  **91052 Erlangen (DE)**
- **MUSSARD, Emilie**
  **1323 Romainmôtier (CH)**

(74) Representative: **Maier, Daniel Oliver**
**Siemens AG**
**Postfach 22 16 34**
**80506 München (DE)**

(54) **METHOD AND SYSTEM FOR IMPROVING INCOHERENT UNDERSAMPLING IN MRI**

(57)     The present invention concerns a system and a method for decreasing MRI data acquisition time when imaging an object, the method comprising:
- acquiring (101) MRI data for the object to be imaged;
- processing (102) the acquired MRI data in order to create an image of said object;
- creating said image of the object based on the processed data;
the method according to the invention being characterized in that it comprises generating an incoherent sampling pattern comprising a jittered k-space sampling trajectory for acquiring said MRI data.

FIG 1

EP 3 855 201 A1

**Description**

The present disclosure is directed, in general, to imaging techniques for imaging biological objects, like tissues, using Magnetic Resonance Imaging (MRI) techniques. More specifically, the present invention is directed to methods and systems for decreasing acquisition times in MRI.

While MRI became a major tool for medical imaging, it still suffers from some disadvantages compared to other existing imaging techniques, one of said disadvantages being notably the relatively long time required for image acquisition.

Indeed, due to both physical and physiological constraints, acquisition times in MRI are long compared to some other medical imaging techniques like computed tomography (CT). This impedes patient comfort and renders MRI susceptible to motion artifacts. In particular, lengthy acquisition times in MRI might become problematic in case of uncooperative patients, patients in acute pain, or in paediatrics. Furthermore, patient throughput is very low which makes the MRI together with its expensive hardware a cost-inefficient modality.

One solution for decreasing acquisition times is to accelerate acquisition sequences by acquiring fewer samples. Indeed, since the acquisition time usually scales linear to the number of samples, decreasing the number of samples also decreases the acquisition time. Within this field, a method of interest is Compressed Sensing (CS), which is an acceleration technique that became popular in MRI. CS follows a mathematical concept originating from information and approximation theory [1], previously developed in the field of signal processing [2]. It implies to reconstruct signals from incoherently undersampled data exploiting the prior knowledge that the signal is compressible. The latter requires the signal to be sparse in a transform domain (e.g. Wavelet domain); the image signal is then approximated by encoding only the most important coefficients [3]. The application of CS to MRI was proposed by Lustig et al. [4] with the following conditions that need to be fulfilled:

    i) transform sparsity,
    ii) incoherent sampling to produce noise-like artifacts, and
    iii) nonlinear reconstruction enforcing sparsity in the transform domain and consistency of the reconstruction with the acquired data.

In order to answer the second condition for using CS in practice, an incoherent undersampling pattern is required. Furthermore, the design of the undersampling pattern must be computed in such a way that a sensible trajectory through k-space can be drawn, i.e. one that yields the desired contrast. Also, other considerations must be taken into account, as there are physiological considerations and physical constraints to respect. Strong gradients are required if the difference between two consecutive samples in k-space is too large, which might cause eddy currents or nerve stimulation.

For a practical application, it is also important to be able to generate sampling patterns in real time, in order to flexibly adapt to user-defined parameters (depending on e.g. the organ imaged, the field of view, the patient cooperativity, the pathology).

Up to now, different incoherent undersampling patterns were generated. For example:

- Complete random undersampling pattern, e.g. using uniformly distributed random numbers: this pattern is incoherent by nature; however, it produces clusters and relatively large empty spaces between samples. This is not due to the deficiency of a particular random number generator: uniform random samples provide uniform sample placement probability, but not a uniform coverage of the sampling domain. Furthermore, random sampling is very sensitive to system imperfections and is usually impractical. Another reason for which a random pattern would not give as good results as expected is that in k-space most of the energy is in its center, i.e. low frequencies. Therefore, a higher sampling density in the k-space center (thus non-uniform) may result in better images.
- Poisson disc sampling pattern: Poisson-disc [5] is a partly incoherent sampling pattern where samples are chosen from a complete random pattern but set no closer to each other than a defined radius. Simple algorithms draw independent samples from a uniform distribution and each sample is either added or rejected using a distance rejection criterion. However, the problem with Poisson disc pattern is that its generation is long and computationally expensive.

It is therefore desirable to find a method and a system for decreasing the time required for collecting MRI data that overcome the previously mentioned problems, and which is free of any significant degradation of the MRI image quality, providing notably a good mitigation of undersampling artifacts, and fast to not disrupt clinical routine.

Said objective is achieved according to the present invention by a method and a system for decreasing MRI data acquisition time according to the object of the independent claims. Dependent claims present further advantages of the invention.

The present invention proposes a method for decreasing MRI data acquisition time when imaging an object, the method comprising;

- acquiring MRI data for the object to be imaged;
- processing the acquired MRI data in order to create an image of said object;
- creating said image of the object based on the processed data;

the method according to the invention being characterized in that it comprises:

- generating an incoherent sampling pattern comprising a jittered k-space sampling trajectory, e.g. a jittered Cartesian spiral phyllotaxis k-space sampling trajectory, for acquiring said MRI data.

According to the present invention, the incoherent undersampling is realized by using said jittered Cartesian k-space sampling trajectory, preferentially based on a phyllotaxis pattern. Advantageously, the phyllotaxis pattern enables a k-space sampling with variable density, i.e. higher density in the k-space center. The pattern itself and the corresponding trajectories can be flexibly and rapidly computed as the phyllotaxis pattern is based on the Fibonacci series and therefore does not require any optimization step.

Compared to existing techniques, the present invention provides better results (images): for instance, contrary to complete random undersampling patterns, the presently claimed undersampling pattern uses a k-space sampling designed with a variable density distribution which enables to take into account the fact that in k-space most of the energy is located in its center, i.e. low frequencies, while such a variable density distribution is not possible with complete random undersampling patterns. It also provides better results compared to the Poisson disc sampling pattern, because the point-spread function of Poisson-disc is not as incoherent as the undersampling pattern according to the present invention.

The present invention concerns also a system, e.g. an MRI apparatus, configured for imaging an object by carrying out the steps of the previously described method. Said system comprises for instance:

- an imaging system, like the imaging system of an MRI apparatus, configured for acquiring MRI data for the object;
- a memory for storing each of the acquired data;
- a control unit comprising a processor, the control unit being configured for processing the acquired data in order to generate an MRI image of said object;
- optionally a display for displaying said image of the object;

characterized in that the control unit is configured for controlling and performing an incoherent k-space undersampling MRI data acquisition by means of the imaging system, wherein a jittered Cartesian k-space sampling trajectory is used for said acquisition of MRI data.

The foregoing has broadly outlined the features and technical advantages of the present disclosure so that those skilled in the art may better understand the detailed description that follows. In particular, the present invention enables to decrease the acquisition time of MRI data while maintaining the quality of the obtained images for the object.

Additional features and advantages of the disclosure will be described hereinafter that form the object of the claims. Those skilled in the art will appreciate that they may readily use the concept and the specific embodiment disclosed as a basis for modifying or designing other structures for carrying out the same purposes of the present disclosure. Those skilled in the art will also realize that such equivalent constructions do not depart from the spirit and scope of the disclosure in its broadest form.

For a more complete understanding of the present disclosure, and the advantages thereof, reference is now made to the following descriptions taken in conjunction with the accompanying drawings, wherein like numbers designate like objects, and in which:

Figure 1 illustrates a flowchart of a method for decreasing the acquisition time of MRI data according to the invention;

Figure 2 illustrates a system for implementing the claimed method;

Figure 3 illustrates an example of undersampling patterns with various jitter radii;

Figure 4 shows images reconstructed from regular phyllotaxis pattern in comparison to a jittered phyllotaxis pattern.

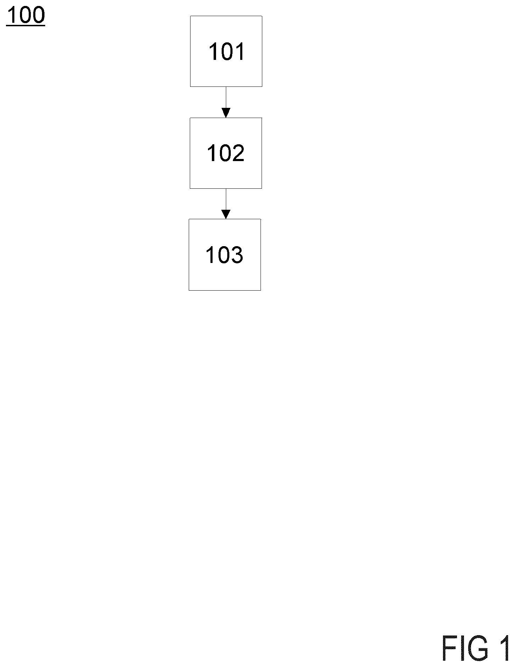

Figures 1 to 4, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

We will now describe in more details the method according to the invention through Figure 1 which describes the different steps of the method 100 carried out by the system according to the invention.

At step 101, the imaging system of an MRI apparatus acquires MRI data. Preferentially, a Cartesian sampling sequence, such as GRE, bSSFP, MPRAGE, MP2RAGE, or SE, is used by the system according to the invention for MRI data acquisition. According to the present invention and contrary to existing techniques, a jittered Cartesian spiral phyllotaxis k-space sampling pattern and an automatically calculated trajectory is used for the incoherent undersampling of the MRI data. Preferentially, the k-space coordinates ($y_n$ and $z_n$) of sampled points on a Cartesian grid are calculated as follows:

$$(y_n, z_n) = round\left(\frac{N_{ky}}{2} * r_n{}^d * \cos(\alpha_n) + \varepsilon, \frac{N_{kz}}{2} * r_n{}^d * \sin(\alpha_n) + \varepsilon\right)$$

where

$$r_n = \sqrt{\frac{n}{N_{Samples}}}, \ \alpha_n = n * \alpha_{Gold}, \text{ and } n \in [0, N_{Samples} - 1]$$

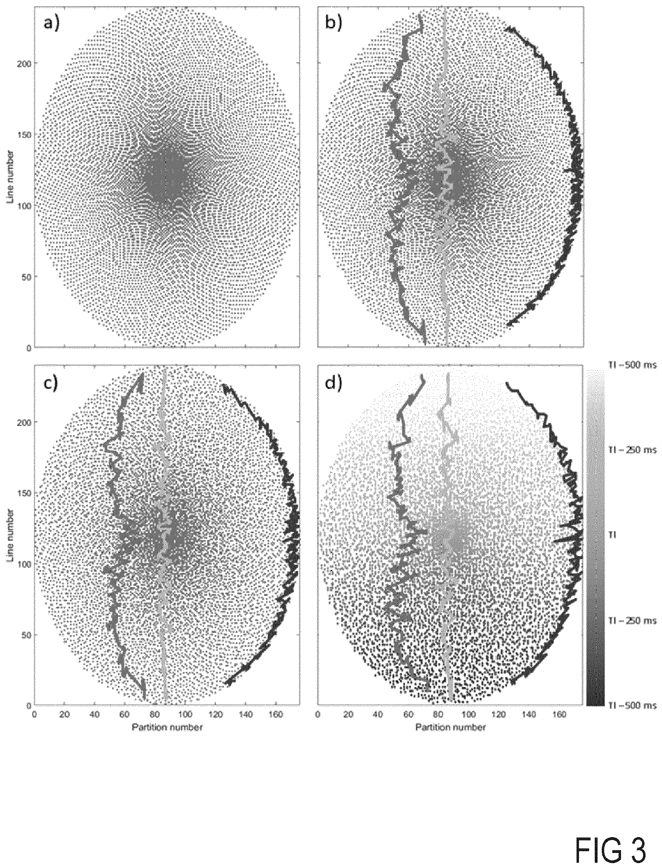

with $N_{samples}$ being the total number of sampled points, $N_{ky}$ and $N_{kz}$ the k-space matrix size for respective phase encoding directions, $\alpha_{Gold}$ the golden angle of the full circumference ($\sim 137.5°$), $d$ a density factor with preferentially, d = 0.5, and $\varepsilon$ a random jitter value configured for further promoting incoherence, wherein the random jitter is preferentially characterized by a distribution of random values with a mean = 0 and, preferentially, a variance = 1.2. Of course, different random distributions of the jitter might be used (also non gaussian). Advantageously, the created sampling pattern has variable density comprising in particular more samples in the centre than in the periphery of k-space. The density factor $d$ further enables a user to tweak the balance between numbers of samples in the centre/periphery of k-space. The higher the value of the density factor $d$ is, the more samples will be acquired in the centre of k-space and the less samples will be acquired at the border of k-space. Depending on the object scanned, the sampling density allows to find a good balance between low and high frequencies sampling. Typically, the density factor $d$ ranges between 0.2 and 0.8. A sampling pattern generated with the above-mentioned typical parameters is shown in Figure 3, wherein grey spots represent acquired samples. The different subfigures show phyllotaxis patterns using various jitters, including

- no jitter in subfigure 3(a): this is the original Cartesian phyllotaxis spiral used for the computation of the undersampling pattern;
- 0.5 jitter in Fig. 3(b): the added jitter equals 0.5 voxels and three example trajectories through k-space are shown (one colour per read-out block);
- 1.2 jitter in Fig. 3(c): the added jitter equals 1.2 voxels and three example trajectories through k-space are shown (one colour per read-out block);
- 2.4 jitter in Fig. 3(d): the added jitter equals 2.4 voxels and three example trajectories through k-space are shown (one colour per read-out block).

In Fig. 3, the central line numbers are acquired at approximately TI while central $k_z$ numbers (partition number) are acquired around TA/2. Preferentially, the jitter value is automatically selected in function of a user-defined k-space grid coverage value and a user-defined undersampling artifacts incoherence value.

The acquisition of the entire k-space data is then separated in several read-out blocks, i.e. the acquisition of a subset of k-space samples. Based on the obtained jittered pattern, k-space trajectories are subsequently derived for each readout block considering user-defined parameters $N_{samplesPerBlock}$ (= number of acquired phase-encoding steps per read-out block), $N_{kz}$ (= number of second phase encoding direction($k_z$) in the MRI acquisition matrix) and $N_{Blocks}$ (= number of blocks performed during the acquisition). The generation of the trajectory is in particular realized as follows: First, all sampled points are stored by the system according to the invention in a table $t$ with their corresponding Cartesian k-space coordinates $k_y$ and $k_z$.

Then, an algorithm is configured for calculating the k-space trajectory by sorting the sampled points so that a prescribed sequence timing with NBlocks read-out blocks that consists of $N_{samplesPerBlock}$ k-space sampling points is achieved. For instance, said sorting is realized according to the following:

```
SORT(t, ascending by k_y)

x_s = N_kz / N_Block

x_i = 0

WHILE x_i * x_s * N_Blocks < N_Samples

        SORT(t (RANGE(x_i* x_s * N_Blocks, (x_i + 1) * x_s * N_Blocks)

        ), ascending by k_z)

        INCREMENT x_i

ENDWHILE
```

where:

> $x_s$ and $x_i$ are variables of the algorithm;
> SORT(*v*, *criterion*) is a function which orders the rows of a sampling table v according to a *criterion*. The criterion could be, for example, sorting a table of sampling points ascending by ky positions;
> v(RANGE(*a*, *b*)) returns the rows of a sampling table v in the interval [*a*, *b*].

The resulting trajectory traverses k-space in an arc-wise fashion using coordinates from the jittered phyllotaxis pattern as illustrated in Figure 3c, notably sampling the k-space centre always in the middle (also time-wise) of the trajectory. This enables to choose the number of k-space points sampled in one read-out block completely independently from the number of first or second phase encoding points given by the user-defined matrix size. Preferentially, a protocol configured for limiting the step size between successive k-space sampled points is used in order to avoid increased eddy current effects (due to larger phase gradient amplitudes), which in turn implies a minimum number of samples (i.e. sampled points) per block. Having the said flexibility of the sequence user to select the samples per read-out block (i.e. the present invention enables a user to select a preferred length of the read-out block through the parameter $N_{samplesPerBlock}$), preferentially, the method comprises increasing the number of samples per block beyond the matrix size dimension. This results in a further reduction of the total scan time - of course being limited on this end by unwanted contrast mechanisms (e.g. increased $T_1$ blurring), reduced tissue contrast and the length of the read-out blocks.

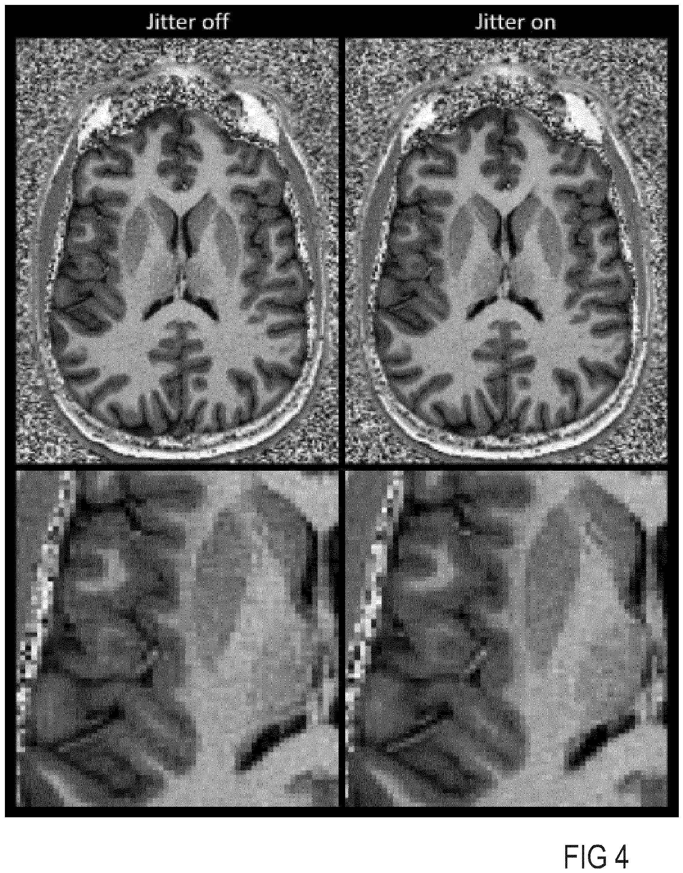

At step 102, the system according to the invention processes the acquired MRI data in order to create an image of said object. For this purpose, standard image reconstruction techniques (e.g. CS reconstruction) based on the sampled dataset might be used. Figure 4 shows for instance the effect of jitter on images undersampled with phyllotaxis pattern and reconstructed with CS. The top row shows a transversal slice from volumes acquired with an acceleration factor R=4 (the acceleration factor R is defined as the ratio of the amount of k-space data required for a fully sampled image (according to the Nyquist-Shannon theorem) to the amount collected in an accelerated acquisition like the present one), while the bottom row zooms into the top images. Left-hand side images were acquired using a regular undersampling pattern without any jitter and the right-hand side images were acquired using an undersampling pattern with a jitter value of 1.2 voxels. According to the present invention, the jitter is uniformly distributed with a mean of 0 and a variance of 1.2 voxels. The artifacts which are removed using the jitter are visible on the non-jittered images as an increase of noise in the grey nuclei region and at the white matter / grey matter boundaries.

At step 103, the system creates the image of the object based on the processed data, and optionally displays the created image, as shown in Fig. 4.

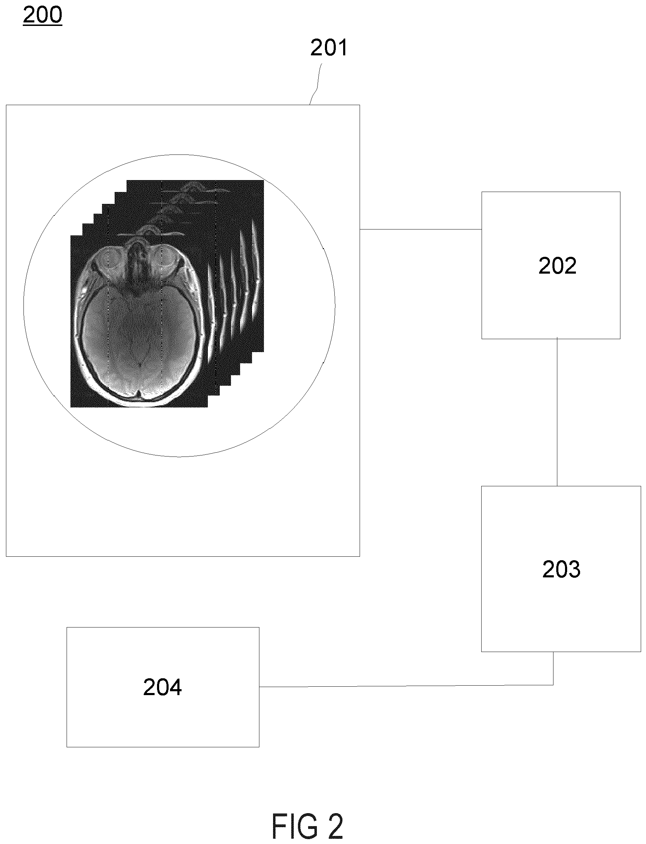

Finally, Figure 2 schematically illustrates an embodiment of a system 200 according to the invention. Said system 200 is notably configured for decreasing MRI data acquisition time when imaging an object. The system 200 comprises:

- an MRI imaging system 201, configured for acquiring MRI data for voxels of the biological object;
- a memory 202, connected to the MRI imaging system 201, for storing each acquired MRI data;
- a control unit 203 connected to the memory 202 and to the MRI imaging system 201. The control unit 203 comprises notably a processor configured for processing the acquired MRI data in order to generate an image of said object;
- optionally, a display 204 for displaying the generated image;

the system 200 being characterized in that it is configured for controlling and performing an incoherent k-space undersampling MRI data acquisition by means of the imaging system, wherein a jittered Cartesian k-space sampling pattern and trajectory is used for said acquisition of MRI data.

To summarize, the present invention proposes to use jittering on a coherent undersampling pattern, like the phyllotaxis pattern. This leads to a good trade-off between incoherence, sampling distribution and computational time, wherein the jitter enables to improve the image reconstruction.

List of citations:

[1] D. L. Donoho, "Compressed sensing," IEEE Trans. Inf. Theory, vol. 52, no. 4, pp. 1289-1306, 2006.

[2] E. J. Candes and M. B. Wakin, "An Introduction To Compressive Sampling," IEEE Signal Process. Mag., vol. 25, no. 2, pp. 21-30, 2008

[3] G. Puy, P. Vandergheynst, R. Gribonval, and Y. Wiaux, "Universal and efficient compressed sensing by spread spectrum and application to realistic Fourier imaging techniques," EURASIP J. Adv. Signal Process., vol. 2012, no. 1, p. 6, 2012.

[4] M. Lustig, D. Donoho, and J. M. Pauly, "Sparse MRI: The application of compressed sensing for rapid MR imaging," Magn. Reson. Med., vol. 58, no. 6, pp. 1182-1195, 2007.

[5] T. R. Jones, "Efficient Generation of Poisson-Disk Sampling Patterns," J. Graph. Tools, 2011.

[6] C. Forman, D. Piccini, R. Grimm, J. Hutter, J. Hornegger, and M. O. Zenge, "High-resolution 3D whole-heart coronary MRA: a study on the combination of data acquisition in multiple breath-holds and 1D residual respiratory motion compensation," MAGMA, vol. 27, no. 5, pp. 435-443, 2014.

[7] F. A. Breuer et al., "Controlled aliasing in volumetric parallel imaging (2D CAIPIRINHA)," Magn. Reson. Med., vol. 55, no. 3, pp. 549-556, 2006

**Claims**

1. A method (100) for decreasing MRI data acquisition time when imaging an object, the method comprising:

   - acquiring (101) MRI data for the object to be imaged;
   - processing (102) the acquired MRI data in order to create an image of said object;
   - creating said image of the object based on the processed data;

   the method according to the invention being **characterized in that** it comprises generating an incoherent sampling pattern comprising a jittered k-space sampling trajectory for acquiring said MRI data.

2. The method of claim 1, wherein the jittered k-space sampling trajectory is a jittered Cartesian spiral phyllotaxis k-space sampling trajectory.

3. The method of claim 1 or 2, wherein processing the acquired MRI data comprises using Compressed Sensing reconstruction techniques.

4. The method according to one of the claims 1 to 3, wherein at least one of the following Cartesian sampling sequences is used for acquiring (101) the MRI data:

   - GRE;
   - bSSFP;
   - MPRAGE;
   - MP2RAGE;
   - SE.

5. The method according to one of the claims 2 to 4, wherein the k-space coordinates ($y_n$ and $z_n$) of trajectory sampled

points on a Cartesian grid are calculated as follows:

$$(y_n, z_n) = round\left(\frac{N_{ky}}{2} * r_n^{\ d} * \cos(\alpha_n) + \varepsilon, \frac{N_{kz}}{2} * r_n^{\ d} * \sin(\alpha_n) + \varepsilon\right)$$

where

$$r_n = \sqrt{\frac{n}{N_{Samples}}}, \ \alpha_n = n * \alpha_{Gold}, \text{ and } n \in [0, N_{Samples} - 1]$$

with $N_{samples}$ being the total number of sampled points, $N_{ky}$ and $N_{kz}$ the k-space matrix size for respective phase encoding directions, $\alpha_{Gold}$ the golden angle of the full circumference, $d$ a density factor and $\varepsilon$ a random jitter value configured for further promoting incoherence.

6. The method according to claim 5, wherein d ranges between 0.2 and 0.8, with preferentially d = 0.5, and the random jitter is preferentially **characterized by** a distribution of values with a mean = 0 and optionally a variance = 1.2.

7. The method according to one of the claims 1 to 6, wherein an algorithm is used for calculating the k-space sampling trajectory by sorting the sampled points so that a prescribed sequence timing in blocks of $N_{samplesPerBlock}$ is achieved.

8. The method according to claim 7, wherein the sorting is realized according to the following:

```
SORT(t, ascending by ky)
xs = Nkz / NBlock
xi = 0
WHILE xi * xs * NBlocks < NSamples
        SORT(t (RANGE(xi* xs * NBlocks, (xi + 1) * xs * NBlocks)
        ), ascending by kz)
        INCREMENT xi
ENDWHILE
```

where:

$x_s$ and $x_i$ are variables of the algorithm;
SORT($v$, *criterion*) is a function which orders the rows of a sampling table $v$ according to a *criterion*. The criterion could be, for example, sorting a table of sampling points ascending by ky positions;
v(RANGE($a$, $b$)) returns the rows of a sampling table v in the interval [a, b].

9. System (200) for decreasing MRI data acquisition time when imaging an object, the system comprising:

   - an MRI imaging system (201), configured for acquiring MRI data for voxels of the biological object;
   - a memory (202), connected to the MRI imaging system (201), for storing each acquired MRI data;
   - a control unit (203) connected to the memory (202) and to the MRI imaging system (201);

the system (200) being **characterized in that** it is configured for controlling and performing an incoherent k-space undersampling MRI data acquisition by means of the imaging system, wherein a jittered Cartesian k-space sampling trajectory is used for said acquisition of MRI data.

100

FIG 1

200

201

202

203

204

FIG 2

FIG 3

FIG 4

Europäisches
Patentamt

European
Patent Office

Office européen
des brevets

**EUROPEAN SEARCH REPORT**

Application Number

EP 20 15 3458

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MUSSARD E.P.C. ET AL.: "High-resolution 3D T2 mapping of the Brain Using T2-prepared Cartesian Spiral Phyllotaxis FLASH and Compressed Sensing", PROCEEDINGS OF THE INTERNATIONAL SOCIETY FOR MAGNETIC RESONANCE IN MEDICINE, 25TH ANNUAL MEETING & EXHIBITION, no. 3725, 7 April 2017 (2017-04-07), XP040691293, Honolulu, HI, USA | 1-4,7,9 | INV. G01R33/561 ADD. G01R33/48 |
| Y | * the whole document * | 5,6 | |
| A | | 8 | |
| | ----- | | |
| Y | FORMAN CHRISTOPH ET AL: "High-resolution 3D whole-heart coronary MRA: a study on the combination of data acquisition in multiple breath-holds and 1D residual respiratory motion compensation", MAGNETIC RESONANCE MATERIALS IN PHYSICS, BIOLOGY AND MEDICINE, SPRINGER, DE, GB, vol. 27, no. 5, 9 January 2014 (2014-01-09), pages 435-443, XP035397692, ISSN: 0968-5243, DOI: 10.1007/S10334-013-0428-X [retrieved on 2014-01-09] * section "Data acquisition in breathhold" * | 5,6 | |
| | ----- | | |
| | -/-- | | |

TECHNICAL FIELDS
SEARCHED (IPC)

G01R

The present search report has been drawn up for all claims

| Place of search | Date of completion of the search | Examiner |
|---|---|---|
| Munich | 13 July 2020 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 20 15 3458

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | Emilie Mussard ET AL: "Accelerated MP2RAGE imaging using Cartesian phyllotaxis readout and compressed sensing reconstruction", Magnetic Resonance in Medicine, 16 March 2020 (2020-03-16), pages 1881-1894, XP055713755, DOI: 10.1002/mrm.28244 Retrieved from the Internet: URL:https://onlinelibrary.wiley.com/doi/full-xml/10.1002/mrm.28244 [retrieved on 2020-07-10] * the whole document * | | |

-----

**TECHNICAL FIELDS SEARCHED        (IPC)**

The present search report has been drawn up for all claims

| Place of search | Date of completion of the search | Examiner |
|---|---|---|
| Munich | 13 July 2020 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. L. DONOHO.** Compressed sensing. *IEEE Trans. Inf. Theory,* 2006, vol. 52 (4), 1289-1306
- **E. J. CANDES ; M. B. WAKIN.** An Introduction To Compressive Sampling. *IEEE Signal Process. Mag.,* 2008, vol. 25 (2), 21-30
- **G. PUY ; P. VANDERGHEYNST ; R. GRIBONVAL ; Y. WIAUX.** Universal and efficient compressed sensing by spread spectrum and application to realistic Fourier imaging techniques. *EURASIP J. Adv. Signal Process.,* 2012, vol. 2012 (1), 6
- **M. LUSTIG ; D. DONOHO ; J. M. PAULY.** Sparse MRI: The application of compressed sensing for rapid MR imaging. *Magn. Reson. Med.,* 2007, vol. 58 (6), 1182-1195
- **T. R. JONES.** Efficient Generation of Poisson-Disk Sampling Patterns. *J. Graph. Tools,* 2011
- **C. FORMAN ; D. PICCINI ; R. GRIMM ; J. HUTTER ; J. HORNEGGER ; M. O. ZENGE.** High-resolution 3D whole-heart coronary MRA: a study on the combination of data acquisition in multiple breath-holds and 1D residual respiratory motion compensation. *MAGMA,* 2014, vol. 27 (5), 435-443
- **F. A. BREUER et al.** Controlled aliasing in volumetric parallel imaging (2D CAIPIRINHA). *Magn. Reson. Med.,* 2006, vol. 55 (3), 549-556